# EUROPEAN PATENT SPECIFICATION

(11) **EP 2 394 787 B1**
(45) Date of publication and mention of the grant of the patent: **29.05.2019**
(21) Application number: 10738365.5
(22) Date of filing: 04.02.2010
(51) Int. Cl.: B24B 37/00, H01L 21/02, H01L 21/16, C30B 25/18, C30B 29/36, C30B 33/00

(54) **MANUFACTURING METHOD FOR A SILICON CARBIDE MONOCRYSTAL SUBSTRATE**
HERSTELLUNGSVERFAHREN FÜR SILIZIUMKARBID-EINZELKRISTALLSUBSTRAT
PROCÉDÉ DE FABRICATION D'UN SUBSTRAT DE MONOCRISTAUX DE CARBURE DE SILICIUM

(30) Priority: 04.02.2009 JP 2009023581; 13.07.2009 JP 2009164622
(43) Date of publication of application: 14.12.2011
(73) Proprietor: Hitachi Metals, Ltd., Tokyo 105-8614 (JP)
(72) Inventor: HORI, Tsutomu, Unknown (JP); HIROOKA, Taisuke, Mishima-gun Osaka 618-0013 (JP)
(74) Representative: Grünecker Patent- und Rechtsanwälte PartG mbB
(86) International application number: PCT/JP2010/000673
(87) International publication number: WO 2010/090024

(56) References cited:
- WO-A1-2005/093796
- WO-A1-2005/093796
- JP-A- 9 183 700
- JP-A- 9 183 700
- JP-A- 10 199 848
- JP-A- 10 199 848
- JP-A- 2005 064 392
- JP-A- 2005 064 392
- JP-A- 2006 032 655
- JP-A- 2006 032 655
- JP-A- 2008 179 655
- JP-A- 2008 179 655

## Description

### TECHNICAL FIELD

The present invention relates to a method for producing a silicon carbide single crystal substrate.

### BACKGROUND ART

A silicon carbide semiconductor has a larger breakdown field, a higher saturated drift velocity of electrons, and a higher thermal conductivity than a silicon semiconductor. Therefore, research and development practices have been actively conducted using a silicon carbide semiconductor to realize a power device which is capable of larger current operation at a higher temperature and a higher rate than a conventional silicon device. Especially, development of a high efficiency switching device for motors usable for electric bicycles, electric vehicles and hybrid vehicles is a target of attention because such motors are AC-driven or inverter-controlled. For realizing such a power device, a silicon carbide single crystal substrate for epitaxially growing a high quality silicon carbide semiconductor layer is necessary.

In the meantime, a blue diode as a light source for recording information at a high density, and a white diode as a light source replacing a fluorescent light or a light bulb, are now highly needed. Such a light emitting device is produced using a gallium nitride semiconductor. As a substrate used for forming a high quality gallium nitride semiconductor layer, a silicon carbide single crystal substrate is used. Therefore, as a substrate used for producing a semiconductor device expected to have a growing demand in the future, for example, a silicon carbide semiconductor device or a gallium nitride semiconductor device, a high quality silicon carbide single crystal substrate having a high surface flatness and a high smoothness is desired.

Like other semiconductor single crystal substrates, a silicon carbide single crystal substrate is produced by: cutting out a substrate having a prescribed thickness from an ingot, flattening a surface of the substrate by mechanical polishing, then improving the flatness and smoothness of the surface by chemical mechanical polishing (hereinafter, referred to simply as "CMP"), and finishing the surface as a mirror surface. However, the silicon carbide single crystal, which has a higher hardness and a higher corrosion resistance than other semiconductor materials, is poor in processability for producing such a substrate. For this reason, it is generally difficult to provide a silicon carbide single crystal substrate having a high smoothness.

For mechanical polishing a silicon carbide single crystal substrate, abrasive grains of diamond or the like which is harder than silicon carbide are used as a polishing material. In this case, in the surface of the silicon carbide single crystal substrate which has been polished with the diamond abrasive grains, tiny scratches are made in accordance with the diameter of the diamond abrasive grains. In addition, a affected layer which is mechanically distorted is formed on the surface of the silicon carbide single crystal substrate.

The tiny scratches and the affected layer thus caused are removed by CMP. CMP is a processing technique for polishing a surface of a semiconductor single crystal substrate, by which a target of processing is converted into an oxide or the like using a chemical reaction such as oxidation or the like, and the generated oxide is removed with abrasive grains which are softer than the target of processing. According to this technique, a highly smooth surface can be formed without causing distortion at all to the surface of the target of processing.

Patent Document 1 discloses smoothing a surface of a silicon carbide single crystal substrate after a mechanical polishing, by CMP using a silica slurry. However, when only a silica slurry is used as in Patent Document 1, it takes a long time to smooth the surface because the reactivity of the slurry to silicon carbide is low.

Patent Document 2 discloses adding an oxidant to a polishing slurry used for CMP performed on the silicon carbide single crystal substrate. According to Patent Document 2, CMP is performed in the state where the oxidant is present on the surface to be polished, and so the polishing rate is increased and a hard material such as silicon carbide or the like can be polished efficiently even at a low processing pressure.
JP2005064392A, JP2008179655A, WO2005/093796A, JP9183700A, JP10199848A and JP2006032655A also disclose methods for producing silicon carbide single cystal substrates.

### CITATION LIST

### PATENT LITERATURE

Patent Document 1: Japanese Laid-Open Patent Publication No. 2005-260218
Patent Document 2: Japanese Laid-Open Patent Publication No. 2001-205555

### SUMMARY OF INVENTION

### TECHNICAL PROBLEM

The present inventors used the polishing slurry disclosed in each of Patent Documents 1 and 2 to finish a surface of a silicon carbide single crystal substrate as a mirror surface by CMP and epitaxially grew a silicon carbide semiconductor layer or a gallium nitride semiconductor layer on the smoothed silicon carbide single crystal substrate. Regardless of whether the polishing slurry contained an oxidant or not, problems occurred that, for example, the surface of the grown silicon carbide semiconductor layer had concaved and convexed portions or striped step bunching.

The present invention has an object of solving such problems and providing a silicon carbide single crystal substrate usable for growing a silicon carbide semiconductor layer or the like having a smooth and high quality surface, and a method for producing the same.

### SOLUTION TO PROBLEM

The above identified problems are solved by the method for producing a silicon carbide single crystal substrate in accordance with claim 1. Preferred embodiments are disclosed in dependent claims 2 to 7.

### ADVANTAGEOUS EFFECTS OF INVENTION

According to the present invention, the surface of the main face is smooth, and the oxide of silicon carbide does not remain on the main face. Therefore, a high quality silicon carbide semiconductor layer or gallium nitride semiconductor layer having no defect can be formed on the main face of the silicon carbide single crystal substrate.

### BRIEF DESCRIPTION OF DRAWINGS

FIGS. **1(a)** and **(b)** are, respectively, a schematic view of a silicon carbide semiconductor layer formed on a conventional silicon carbide single crystal substrate not processed with CMP after being polished with diamond abrasive grains, and a schematic view of a silicon carbide semiconductor layer formed on a conventional silicon carbide single crystal substrate processed with CMP after being polished with diamond abrasive grains.
FIGS. **2(a)** and **(b)** are, respectively, a schematic cross-sectional view of a silicon carbide semiconductor layer formed on a conventional silicon carbide single crystal substrate not processed with CMP after being polished with diamond abrasive grains, and a schematic cross-sectional view of a silicon carbide semiconductor layer formed on a conventional silicon carbide single crystal substrate processed with CMP after being polished with diamond abrasive grains.
FIG. **3** is a flowchart illustrating a reference method for producing a silicon carbide single crystal substrate in Embodiment 1, which is not according to the present invention.
FIGS. **4(a)** through **(c)** are each a cross-sectional view of a step in the reference method for producing a silicon carbide single crystal substrate in Embodiment 1, which is not according to the present invention.
FIG. **5** shows an example of a structure of a peroxometallate ion.
FIG. **6** is a flowchart illustrating a method for producing a silicon carbide single crystal substrate in Embodiment 2 according to the present invention.
FIGS. **7(a)** through **(d)** are each a cross-sectional view of a step in the method for producing a silicon carbide single crystal substrate in Embodiment 2 according to the present invention.

### DESCRIPTION OF EMBODIMENTS

The present inventors examined the cause of the following in detail: when a silicon carbide single crystal substrate is produced by CMP using a polishing slurry described in each of Patent Documents 1 and 2, specifically, each of a polishing slurry containing silica as abrasive grains and also an oxidant added thereto, and a polishing slurry containing silica as abrasive grains but not containing an oxidant, a defect is caused in a silicon carbide semiconductor layer grown on the silicon carbide single crystal substrate.

Specifically, the present inventors produced a silicon carbide single crystal substrate by CMP using each of a polishing slurry containing silica as abrasive grains and also an oxidant added thereto, and a polishing slurry containing silica as abrasive grains but not containing an oxidant, and then grew a silicon carbide semiconductor layer on the silicon carbide single crystal substrate. Then, various analyses were performed. CMP is considered to influence the smoothness of the surface of the growing silicon carbide semiconductor layer. Therefore, the present inventors grew a silicon carbide semiconductor layer on a silicon carbide single crystal substrate produced without CMP, namely, a silicon carbide single crystal substrate not processed by CMP after being polished with diamond abrasive grains. Then, the same analyses were performed.

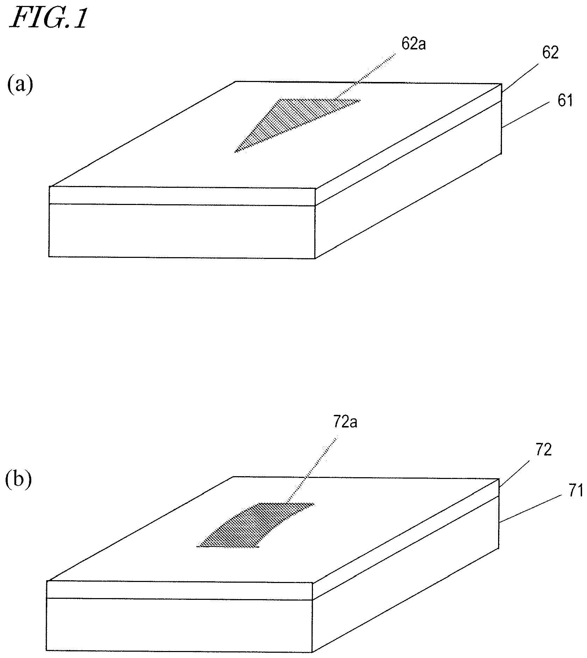

FIG. **1(a)** schematically shows a silicon carbide semiconductor layer **62** formed on a silicon carbide single crystal substrate **61** not processed by CMP. The silicon carbide semiconductor layer 62 is an epitaxially grown layer lattice-matched with the silicon carbide single crystal substrate **61.** However, the grown silicon carbide semiconductor layer contains a different phase portion **62a** of a crystallographically different polytype from that of the silicon carbide single crystal substrate **61.** For example, where the silicon carbide single crystal substrate **61** is a 4H-SiC substrate, the silicon carbide semiconductor layer **62** should be of 4H-SiC. However, the different phase portion **62a** is of a different crystal system. It can be confirmed that the different phase portion **62a** is of a different crystal system by detecting the physical properties unique to each polytype by means of an optical technique or an electric technique. The present inventors performed an experiment of growing the silicon carbide semiconductor layer **62** on the silicon carbide single crystal substrate **61** formed of 4H-SiC and polished with diamond abrasive grains, and evaluated the crystal of the silicon carbide semiconductor layer **62** by photoluminescence. Light emission derived from 3C-SiC was observed at many sites in addition to the light emission derived from 4H-SiC.

FIG. **1(b)** schematically shows a silicon carbide semiconductor layer **72** formed on a silicon carbide single crystal substrate **71** polished using each of a polishing slurry containing an oxidant and a polishing slurry not containing an oxidant. Regardless of whether the polishing slurry contains an oxidant or not, the silicon carbide semiconductor layer **72** has a step bunching **72a.** As a result of evaluating the crystal of the silicon carbide semiconductor layer **72** by photoluminescence, only light emission derived from 4H-SiC, which is of the same polytype as that of the silicon carbide single crystal substrate **71,** was observed. Namely, it was found that the silicon carbide semiconductor layer **72** is of uniform 4H-SiC crystallographically although having the step bunching **72a** in the surface thereof. The surface of the silicon carbide single crystal substrate **71** before the formation of the silicon carbide semiconductor layer **72** was analyzed by means of a usual surface analysis technique such as observation with an optical microscope, x-ray photoelectron spectroscopy or the like. Scratches or the like causing the step bunching **72a** were not detected.

From these results, it was found that the silicon carbide single crystal substrate before CMP and the silicon carbide single crystal substrate after CMP are common in having an abnormal portion in the grown silicon carbide semiconductor layer but that the abnormal portions are different crystallographically. This difference is presumed to depend on the state of the surface of the silicon carbide single crystal substrate as described below.

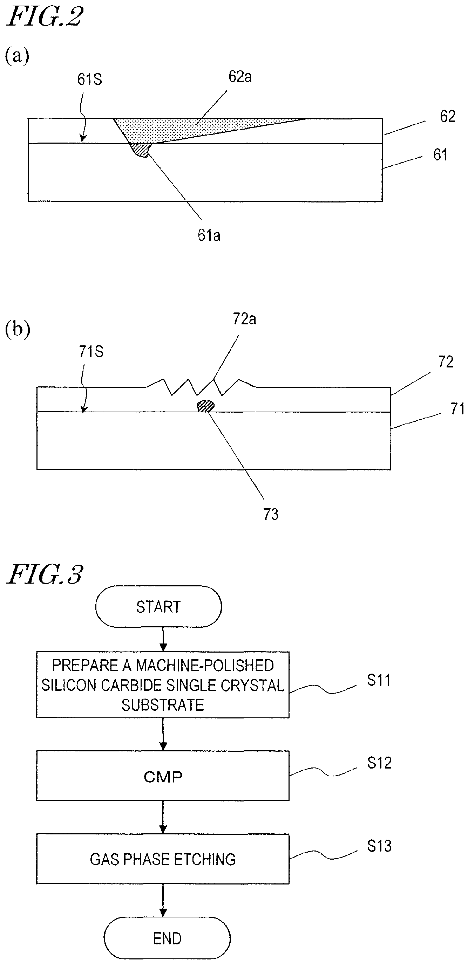

It is considered that as shown in FIG. **2(a)****,** the silicon carbide single crystal substrate **61** not processed by CMP after being polished with diamond abrasive grains has a affected layer **61a,** having a very poor crystallinity due to mechanical polishing performed using the abrasive grains, from a surface **61S** of the silicon carbide single crystal substrate **61** to the inside thereof. Because the crystallinity of the affected layer **61a** is poor, normal homoepitaxial growth cannot be provided from the affected layer **61a** and a crystallographically dissimilar different phase portion **62a** is grown.

By contrast, it is presumed that as shown in FIG. **2(b)****,** in a part of a surface 71S of the silicon carbide single crystal substrate **71** processed by CMP, a surface residual substance **73** which is extremely thin and so almost impossible to be detected by usual surface analysis is generated or remains and prevents epitaxial growth of the silicon carbide semiconductor layer **72.** In this case, the entirety of the surface **71S** of the silicon carbide single crystal substrate **71** is considered to be almost uniform crystallographically. It is considered that the crystallographically uniform silicon carbide semiconductor layer **72** is grown owing to this, although the step bunching 72a is caused by the surface residual substance **73** and so morphology is deteriorated.

Even where the polishing slurry does not contain an oxidant, the grown silicon carbide semiconductor layer **72** has the step bunching **72a.** Therefore, the surface residual substance **73** is considered to be generated by oxidation caused by the abrasive grains in the polishing slurry.

As described above, CMP polishes a target of polishing using a chemical reaction and mechanical polishing. When a polishing disc is pressed to a surface of a silicon carbide single crystal substrate in the state where the polishing slurry is present on the surface of the silicon carbide single crystal substrate and the polishing disc is rotated, the abrasive grains in the polishing slurry contact the surface of the silicon carbide single crystal substrate while being strongly pressurized, and so frictional heat is generated. This high-temperature heat locally generated oxidizes silicon carbide in a portion, of the surface of the silicon carbide single crystal substrate, which contacts the abrasive grains. It is considered that at this point, silicon carbide is oxidized by oxygen in silica forming the abrasive grains, in the air or in the polishing slurry and so an oxide containing silicon, carbon and oxygen (composite oxide of Si-C-O) is first generated. Then, when oxidation further proceeds by the frictional heat, carbon is completely oxidized and detached from the surface of the silicon carbide single crystal substrate as carbon dioxide, and so silicon oxide is left. The generated silicon oxide is removed by polishing with the abrasive grains. It is considered that in this manner, the silicon carbide single crystal substrate can be polished using abrasive grains formed of silica or the like which is softer than silicon carbide.

Now, it is assumed that a surface of a silicon carbide single crystal substrate is polished by such a mechanism. It is considered that in the case where the rate at which silicon oxide is polished off with the abrasive grains is higher than the reaction rate at which silicon oxide is generated from the first-formed oxide containing silicon, carbon and oxygen as a result of oxidation of carbon, the oxide containing silicon, carbon and oxygen remains as the surface residual substance **73** after the polishing is performed by CMP. This oxide is considered as not uniformly remaining on the surface of the silicon carbide single crystal substrate **71** but remaining in parts in accordance with the scratches or the like made on the silicon carbide single crystal substrate with the diamond abrasive grains before the polishing is performed by CMP.

The polishing of the surface of the silicon carbide single crystal substrate by CMP is considered to proceed in two stages in this manner. Therefore, it is considered that even where an oxidant for increasing the polishing rate is added to the polishing slurry used for CMP, the surface residual substance **73** remains on the surface of the silicon carbide single crystal substrate after CMP.

CMP is technology developed together with silicon semiconductor technologies. When it was just made possible to produce a relatively large silicon carbide single crystal substrate, no CMP technology capable of finishing the surface of the silicon carbide single crystal substrate with a high smoothness had been developed because of the extreme hardness of silicon carbide as compared with silicon. However, along with the development of technologies disclosed in Patent Documents 1 and 2, it has become possible to provide a highly smooth silicon carbide single crystal substrate by CMP. Hence, it is considered that using today's CMP technology, the silicon carbide single crystal substrate after CMP has a sufficiently high smoothness. The present inventors are considered to have first found that the above-described surface residual substance **73** is present on the surface of the silicon carbide single crystal substrate after CMP.

Based on such presumptions, the present inventors conceived providing a silicon carbide single crystal substrate preferable to grow a high quality silicon carbide semiconductor layer by, after the surface of the silicon carbide single crystal substrate is polished by CMP, further carrying out a step of removing the surface residual substance **73** presumed to be remaining although not confirmed by surface analysis. As described above, the surface residual substance **73** considered to be formed of an oxide containing silicon, carbon and oxygen cannot be removed by an aqueous solution such as hydrofluoric acid or the like. Therefore, the surface residual substance **73** is removed by a gas phase technique, or the surface residual substance **73** is completely oxidized by a gas phase technique and the generated silicon oxide is removed by an aqueous solution such as hydrofluoric acid or the like or by a gas phase technique. In this manner, a silicon carbide single crystal substrate having a main face finished as a mirror surface with no foreign objects can be obtained. Hereinafter, embodiments of a method for producing a silicon carbide single crystal substrate according to the present invention will be described in detail.

### (EMBODIMENT 1, not in accordance with the present invention)

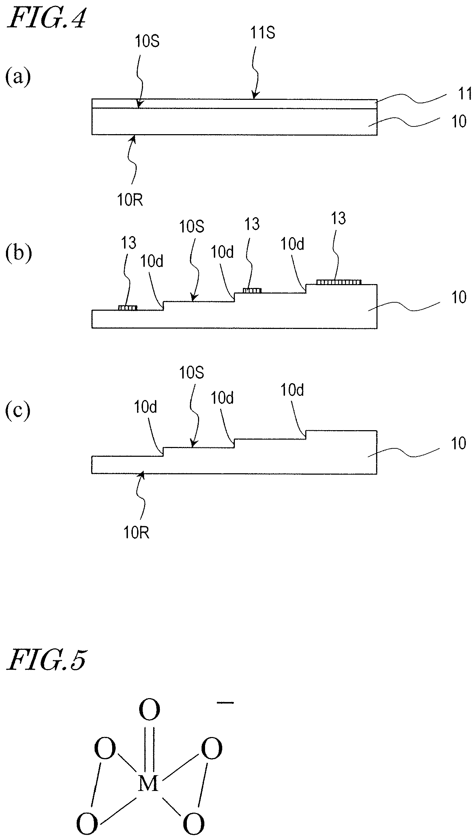

FIG. **3** is a flowchart illustrating a reference method for producing a silicon carbide single crystal substrate in Embodiment 1, which is not according to the present invention. FIGS. **4(a)** through **(c)** are each a cross-sectional view showing a step in the method for producing the silicon carbide single crystal substrate. In this embodiment, a surface residual substance is directly removed by etching using a gas phase technique.

First, as shown in step **S11** and FIG. **4(a)****,** a mechanically polished silicon carbide single crystal substrate **10** is prepared. The silicon carbide single crystal substrate **10** has at least a main face **10S** which is to be finished as a mirror surface. On a surface of the main face 10S, a affected layer **11** having a stress caused by the mechanical polishing is generated. The surface roughness Ra of a surface **11S** of the affected layer **11** is preferably about 1 µm or less. Usually, the affected layer **11** has a thickness approximately the same as the surface roughness, and the thickness of the affected layer 11 is, for example, 1 µm or less.

There is no specific limitation on the surface orientation of the main face 10S of the silicon carbide single crystal substrate **10,** and the method in this embodiment is preferably usable for the silicon carbide single crystal substrate **10** of any orientation. Nevertheless, the present invention is preferably usable especially for producing a silicon carbide single crystal substrate having a hard surface, which is difficult to be finished as a high quality mirror surface by a conventional method. Specifically, the silicon carbide single crystal of the silicon carbide single crystal substrate **10** has a hexagonal structure and is preferably 2H-SiC, 4H-SiC, 6H-SiC or the like. Especially preferably, the silicon carbide single crystal is 4H-SiC or 6H-SiC. The silicon carbide single crystal substrate **10** may have a structure other than the hexagonal structure, and the present invention is applicable to, for example, a silicon carbide single crystal substrate of a cubic structure. Specifically, the silicon carbide single crystal substrate **10** may be of 3C-SiC.

The off-angle θ of the main face 10S of the silicon carbide single crystal substrate **10** with respect to the C axis of the (0001) face is 10 degrees of less, and is appropriately selected in accordance with the type of the semiconductor formed on the silicon carbide single crystal substrate **10.** As the off-angle is smaller, the rate of polishing by CMP performed using a polishing slurry not containing a strong oxidant is slower. Therefore, when the off-angle θ is 4 degrees or less, it is preferable to add a strong oxidant to the polishing slurry described below. Owing to this, it is made possible to finish the silicon carbide single crystal substrate **10,** having an off-angle θ of 4 degrees of less, as having a mirror surface within a practically usable time, and the quality of the silicon carbide semiconductor layer formed on the obtained mirror surface is high.

In this embodiment, only one main face **10S** of the silicon carbide single crystal substrate **10** is finished as a mirror surface, but the other main face **10R** may also be finished as a mirror surface. In this case, for example, CMP or gas phase etching can be performed on the main faces **10S** and **10R** in each step described below.

Next, as shown in step **S12,** the affected layer **11** is removed by CMP to finish the main face **10S** of the silicon carbide single crystal substrate **10** as a mirror surface. The polishing slurry used for CMP contains a dispersion medium and abrasive grains dispersed in the dispersion medium.

As the material of abrasive grains contained in the polishing slurry, silicon oxide, aluminum oxide, cerium oxide, titanium oxide or the like is usable. Among these, a silicon oxide abrasive grain material such as colloidal silica, fumed silica or the like is preferably usable because abrasive grains of such a material are easily dispersed in a liquid uniformly. As the dispersion medium, water is usually used.

In order to increase the polishing rate, the polishing slurry may further contain an oxidant. Namely, an oxidant may be dissolved in the dispersion medium. In this case, it is preferable that the oxidant has a high oxidation capability and contains at least one selected from hydrogen peroxide, ozone, permanganate, peracetic acid, perchlorate, periodic acid, periodate, and hypochlorite. For example, periodic acid disclosed in Japanese Laid-Open Patent Publication No. 2007-27663 is usable. Among the above-listed substances, hydrogen peroxide is preferable in containing no heavy metal element, costing low, being easily available and being low in toxicity.

In the case where the polishing slurry contains an oxidant, it is preferable that the dispersion medium further contains transition metal ions and that peroxide ions ((O₂)²⁻) generated from an oxidant as described above forms peroxometallate ions coordinating to the transition metal ions. It is considered that the peroxometallate ions can increase the rate of the oxidation reaction by being bonded with an oxide of silicon carbide and lowering the activation energy of the oxidation-reduction reaction of the oxide of silicon carbide. FIG. **5** schematically shows an example of a peroxometallate ion. As shown in FIG. **5****,** a peroxide ion is a bidentate ligand, and FIG. **5** shows a pentadentate peroxometallate ion to which two peroxide ions coordinate. The peroxometallate ion promotes the oxidation reaction of silicon carbide as long as at least one peroxide ion coordinates to the peroxometallate ion.

The metal type of the peroxometallate ion is preferably at least one selected from the group consisting of Ti, V, Nb, Ta, Mo, and W. Highly efficient polishing can be performed by using, for example, a solution containing vanadic acid and hydrogen peroxide as described in Japanese Laid-Open Patent Publication No. 2008-179655.

In addition, in order to adjust the pH value of the solution so that the activity or appropriate reactivity of an oxidant described above or the peroxometallate ion is exhibited, an acid such as hydrochloric acid, acetic acid or the like or an alkali such as sodium hydroxide or the like may be added to the dispersion medium of the polishing slurry.

The above-described slurry is prepared. The main face 10S side of the silicon carbide single crystal substrate 10 is pressed to the polishing disc at a pressure of, for example, 50 gf/cm² to 1000 gf/cm² at the face to be polished, and the polishing disc is rotated. While the polishing slurry is supplied onto the polishing disc at a rate of, for example, about 1 ml/min., the main face **10S** of the silicon carbide single crystal substrate **10** is polished. The amount of the polishing slurry to be supplied depends on the size of the polishing disc, the size of the silicon carbide single crystal substrates **10** to be polished, and the number of such substrates. By performing the polishing for several hours to several tens of hours, the affected layer **11** generated on the main face 10S is oxidized by the abrasive grains, and the generated oxide containing silicon, carbon and oxygen is mechanically scraped off by the abrasive grains. In the case where the polishing slurry contains an oxidant, the polishing rate is increased and so the time necessary for the polishing is shortened. In this manner, the silicon carbide single crystal substrate **10** completely deprived of the affected layer **11** and having the main face 10S flattened and finished as a mirror surface is obtained. As shown in FIG. **4(b)****,** although the affected layer **11** is completely removed at this point, a thin surface residual substance **13** of an oxide containing silicon, carbon and oxygen, which cannot be confirmed by surface observation, partially remains.

However, the main face **10S** as a whole has a high flatness and a high smoothness, and stepped features **10d** derived from the silicon carbide single crystal, which are atom-level steps, appear on the surface of the main face **10S.** The surface roughness Ra of the main face **10S** of the silicon carbide single crystal substrate **10** finished as a mirror surface by CMP is preferably 1 nm or less.

Next, as shown in step **S13,** at least a part of the main face **10S** finished as a mirror surface is etched by a gas phase technique. Gas phase etching techniques usable in this embodiment include, for example, ion etching, reactive ion etching, plasma etching, reactive ion beam etching, ion beam etching and the like. Other gas phase etching techniques are also usable.

There is no specific limitation on the type of gas used for gas phase etching. Nevertheless, it is preferable to use gas having reactivity with silicon carbide, for example, fluorine-containing gas such as carbon tetrafluoride, sulfur hexafluoride or the like, hydrogen, or the like. In order to promote oxidation, oxygen may be added. Various etching conditions including the power to be applied are determined by the device used for etching or the like. It is preferable that the etching rate does not exceed 10 µm/h. An etching rate exceeding 10 µm/h is not preferable because such an etching condition is too strong for the main face **10S** of the silicon carbide single crystal substrate **10** and so the main face **10S** may be damaged by collision of ions or the surface morphology of the main face **10S** after etching may be deteriorated.

As described above, the surface residual substance **13** has a small thickness. Therefore, etching by a gas phase technique does not need to be performed for a long time, and it is sufficient to do such etching for an approximate time period in which the surface residual substance **13** can be removed. The gas or the etching conditions may be selected to remove the surface residual substance **13** with priority or to remove the entirety of a portion from a surface of the main face **10S** to a depth of about 100 nm of the silicon carbide single crystal substrate **10** containing the surface residual substance **13.** By etching the surface residual substance **13** using a gas phase technique, the silicon carbide single crystal substrate **10** having the main face 10S deprived of the surface residual substance **13** as shown in FIG. **4(c)** is obtained. With gas phase etching, etching proceeds generally uniformly. Therefore, the surface roughness of the main face **10S** does not change almost at all. For this reason, the main face **10S** flattened and finished as a mirror surface by CMP is maintained. Even after the gas phase etching, the surface roughness Ra of the main face **10S** of the silicon carbide single crystal substrate **10** is still 1 nm or less. The stepped features **10d** derived from the silicon carbide single crystal, which are atom-level steps, are maintained on the surface of the main face **10S.**

As described above, when the etching is performed for an approximate time period in which the surface residual substance **13** can be removed, the crystallinity of the silicon carbide single crystal is not damaged. However, when the silicon carbide single crystal substrate **10** is etched by a thickness equal to or greater than several microns by reactive ion etching, the surface morphology of the main face 10S is significantly deteriorated and the crystallinity in the vicinity of the main face **10S** is also lowered. As a result, it becomes difficult to form a high quality silicon carbide semiconductor layer on the main face **10S.**

The silicon carbide single crystal substrate **10** obtained as above is flat and has the main face **10S** finished as a mirror surface having a surface roughness Ra of 1 nm or less. The surface residual substance **13** does not remain on the main face **10S.** Therefore, a high quality silicon carbide semiconductor layer or gallium nitride semiconductor layer with no striped step bunching can be formed on the main face **10S** of the silicon carbide single crystal substrate **10.** In the case where the polishing slurry contains an oxidant having a high oxidation capability, the time required to finish the main face as a mirror surface by CMP can be short and so a high quality silicon carbide single crystal substrate having a mirror surface can be produced in more economical processing conditions.

### (EMBODIMENT 2)

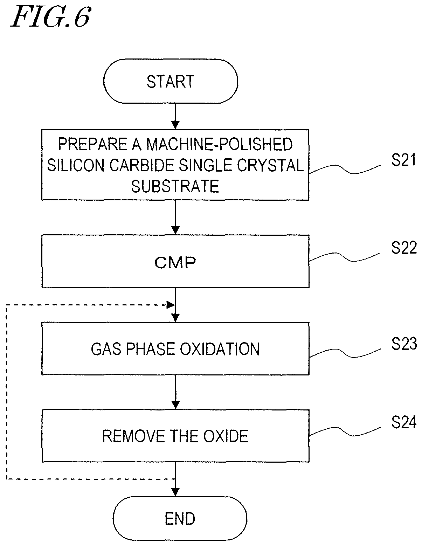

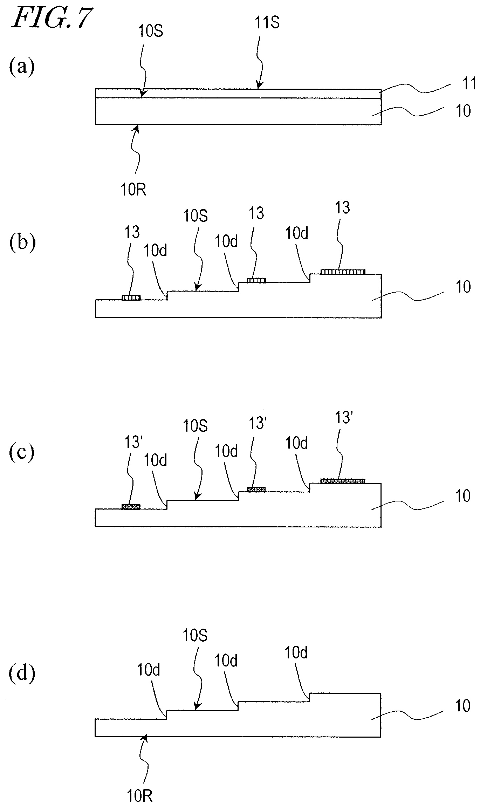

FIG. **6** is a flowchart illustrating a method for producing a silicon carbide single crystal substrate in Embodiment 2 according to the present invention. FIGS. **7(a)** through **(d)** are each a cross-sectional view showing a step in the method for producing the silicon carbide single crystal substrate. In this embodiment, a surface residual substance generated after CMP is oxidized by a gas phase and the generated oxide is removed.

First, as shown in step **S21** and FIG. **7(a)****,** a mechanically polished silicon carbide single crystal substrate **10** is prepared. As shown in step **S22** and FIG. **7(b)****,** CMP is performed on a main face **10S** of the silicon carbide single crystal substrate **10,** and a affected layer **11** generated on the main face **10S** of the silicon carbide single crystal substrate **10** is removed by polishing. The silicon carbide single crystal substrate **10** to be prepared, the polishing slurry to be used for polishing, and the procedure in step **S22** are the same as those in Embodiment 1.

By performing CMP on the main face **10S** of the silicon carbide single crystal substrate **10,** the silicon carbide single crystal substrate **10** completely deprived of the affected layer **11** and having the main face 10S flattened and finished as a mirror surface is obtained. As shown in FIG. **7(b)****,** although the affected layer **11** is completely removed at this point, a thin surface residual substance **13** of an oxide containing silicon, carbon and oxygen, which cannot be confirmed by surface observation, partially remains.

Next, as shown in step S23, at least a part of the main face **10S** finished as a mirror surface is oxidized by a gas phase to form an oxide. By this step, the surface residual substance **13** is oxidized by a gas phase, and as shown in FIG. **7(c)****,** an oxide **13'** formed of silicon oxide is formed. In step **S23,** any technique among wet oxidation, anodic oxidation, plasma oxidation, thermal oxidation, and ozone oxidation can be used.

As described in Embodiment 1, the surface residual substance **13** is thin and so does not need to be oxidized for a long time by a gas phase technique. It is sufficient to do the oxidation for an approximate time period in which the surface residual substance **13** is completely oxidized. The surface residual substance **13** may be oxidized with priority, or the entirety of a portion from a surface of the main face **10S** to a depth of about 100 nm of the silicon carbide single crystal substrate **10** containing the surface residual substance **13** may be oxidized. In the case where the entirety of the surface of the main face **10S** of the silicon carbide single crystal substrate **10** is oxidized, an oxide layer containing an oxide **13'** is formed on the entire surface of the main face **10S** of the silicon carbide single crystal substrate **10.**

In the case where step **S23** is performed by plasma oxidation, the main face **10S** of the silicon carbide single crystal substrate **10** is exposed to oxygen plasma, so that the surface residual substance **13** of an oxide formed of silicon, carbon and oxygen is completely oxidized to form an oxide **13'.** For example, plasma oxidation is performed in an oxygen atmosphere or an atmosphere containing oxygen and inert gas such as Ar or the like at a pressure of about 10⁻¹ to 10² Pa and a power of 0.01 to 2 W/cm². As described below, in the case where the next step of removing the oxide 13' is performed by reactive ion etching, it is preferable to perform plasma oxidation in the same device as the reactive ion etching. The reason for this is that it is not necessary to, for example, transfer the SiC single crystal substrate 10 and so the two steps can be performed continuously merely by replacing the gas.

In the case where step **S23** is performed by thermal oxidation, the silicon carbide single crystal substrate **10** is kept at a high temperature in an oxygen atmosphere, so that the surface residual substance **13** remaining on the main face **10S** of the silicon carbide single crystal substrate **10** is completely oxidized to form an oxide **13'.** For example, the silicon carbide single crystal substrate **10** is kept at a temperature of 900°C to 1500°C and held in an oxygen atmosphere for 10 to 240 minutes.

In the case where step **S23** is performed by ozone oxidation, the main face **10S** of the silicon carbide single crystal substrate **10** is exposed to ozone, so that the surface residual substance **13** remaining on the main face **10S** of the silicon carbide single crystal substrate **10** is completely oxidized to form an oxide **13'.** For example, the silicon carbide single crystal substrate **10** is irradiated with ultraviolet in an ozone flow for 1 to 60 minutes.

Next, as shown in step **S24,** the formed oxide **13'** is removed. The oxide **13'** is formed of silicon oxide and does not contain carbon, and so can be removed by an aqueous solution containing hydrofluoric acid. In this manner, as shown in FIG. **7(d)****,** the silicon carbide single crystal substrate **10** having the main face **10S** deprived of the oxide **13'** is obtained.

Usable as the aqueous solution containing hydrofluoric acid are hydrofluoric acid, buffered hydrofluoric acid (BHF), fluoro-nitric acid, and the like. The oxide **13'** can be removed by being immersed in any of such aqueous solutions.

In the case where a gas phase technique is used, as in Embodiment 1, the oxide **13'** can be removed by ion etching, reactive ion etching, plasma etching, reactive ion beam etching, ion beam etching or the like. Other gas phase etching techniques are also usable. As in Embodiment 1, there is no specific limitation on the type of gas used for gas phase etching. Nevertheless, it is preferable to use gas having reactivity with silicon carbide, for example, fluorine-containing gas such as carbon tetrafluoride, sulfur hexafluoride or the like, hydrogen, or the like. Various etching conditions including the power to be applied are determined by the device used for etching or the like. It is preferable that the etching rate does not exceed 10 µm/h. An etching rate exceeding 10 µm/h is not preferable because such an etching condition is too strong for the main face **10S** of the silicon carbide single crystal substrate **10** and so the main face **10S** may be damaged by collision of ions or the surface morphology of the main face 10S after etching may be deteriorated.

As shown with the dashed line in FIG. **6****,** steps **S23** and **S24,** namely, the step of oxidizing the surface residual substance 13 and the step of removing the oxide **13'** generated by the oxidation is repeated alternately a plurality of times. In order to oxidize the surface residual substance **13** with priority and remove the generated oxide **13'** with priority without damaging the main face **10S** of the silicon carbide single crystal substrate **10,** it is preferable to perform steps **S23** and **S24** under mild conditions. In this case, by performing steps **S23** and **S24** alternately in repetition, the surface residual substance **13** can be removed from the main face **10S** of the silicon carbide single crystal substrate **10** almost completely. Even when the surface residual substance **13** is oxidized only in an area in the vicinity of the outermost surface thereof and oxidation of the surface residual substance **13** is not likely to proceed to the inside by the oxidation technique used, the surface residual substance **13** can be removed from the main face **10S** of the silicon carbide single crystal substrate **10** almost completely by removing the generated silicon oxide and oxidizing the surface residual substance **13** again.

In the case where steps **S23** and **S24** are repeated, one same oxidation technique or different oxidation techniques may be used for step **S23** performed a plurality of times. Similarly, one same removal technique or different removal techniques may be used for step **S24** performed a plurality of times. As described above, it is preferable to perform steps **S23** and **S24** under mild conditions so that the main face **10S** of the silicon carbide single crystal substrate 10 is not damaged and to perform steps **S23** and **S24** alternately, twice or more times, about 10 times, for each. In this case, it is preferable that the final session of step **S24** is performed using an aqueous solution containing hydrofluoric acid. Owing to use of such an aqueous solution, the oxide **13'** can be removed without damaging the main face **10S** of the silicon carbide single crystal substrate **10.** Accordingly, a high quality silicon carbide single crystal substrate **10** without the surface residual substance **13** or the oxide **13'** remaining and having the main face **10S** not being damaged can be produced.

As in Embodiment 1, the silicon carbide single crystal substrate **10** thus obtained is flat and has the main face **10S** finished as a mirror surface having a surface roughness Ra of 1 nm or less. The surface residual substance **13** does not remain on the main face **10S.** Therefore, a high quality silicon carbide semiconductor layer or gallium nitride semiconductor layer with no striped step bunching can be formed on the main face 10S of the silicon carbide single crystal substrate **10.** Especially according to this embodiment, the surface residual substance **13** is first converted into the oxide **13'** formed of silicon oxide by gas phase oxidation. Techniques for etching silicon oxide have been studied in detail and various techniques are known. Therefore, the generated oxide **13'** can be removed almost completely by any of the above-described techniques. Hence, according to this embodiment, the surface residual substance **13** can be removed at a higher efficiency, and so a higher quality silicon carbide semiconductor layer or gallium nitride semiconductor layer with no foreign objects or step bunching on a surface thereof can be formed.

### EXAMPLES

### (REFERENCE EXAMPLE 1)

A peroxide aqueous solution having a concentration of 30 mass% as an oxidant was added to a colloidal silica slurry at a ratio of 0.25 to 1 to produce a polishing slurry. This polishing slurry was used to polish a 4H-SiC single crystal substrate having a diameter of 2 inches by CMP. The off-angle θ of a main face thereof with respect to the C axis of the (0001) face was 4 degrees. The main face had been polished with diamond abrasive grains having a grain diameter of 1 µm or less, and had a surface roughness Ra of 2 nm. The substrate was pressed to the polishing disc at a pressure of 500 gf/cm² at the face to be polished while the polishing disc was rotated at 30 rpm to polish the single crystal substrate. The polishing disc was a buff disc having a diameter of 15 inches. The polishing was performed for 4 hours under such conditions, and thus a silicon carbide single crystal substrate having a main face finished as a mirror surface (surface roughness Ra: 1 nm or less) was obtained.

Then, a surface of the main face was etched by 1 nm by reactive ion etching in an atmosphere of carbon tetrafluoride. On this substrate, a silicon carbide semiconductor layer was grown by CVD. No step bunching was observed, and this substrate was confirmed to have a high quality mirror surface.

### (EXAMPLE 2)

A 4H-SiC single crystal substrate having a diameter of 2 inches was polished by CMP using a colloidal silica slurry. The off-angle θ of a main face thereof with respect to the C axis of the (0001) face was 4 degrees. The main face had been polished with diamond abrasive grains having a grain diameter of 1 µm or less, and had a surface roughness Ra of 2 nm. The substrate was pressed to the polishing disc at a pressure of 500 gf/cm² at the face to be polished while the polishing disc was rotated at 30 rpm to polish the single crystal substrate. The polishing disc was a buff disc having a diameter of 15 inches. The polishing was performed for 4 hours under such conditions, and thus a silicon carbide single crystal substrate having a main face finished as a mirror surface (surface roughness Ra: 1 nm or less) was obtained.

Then, the step of oxidizing a surface of the substrate using plasma in an oxygen atmosphere and removing the oxide layer on the surface by reactive ion etching in an atmosphere of carbon tetrafluoride was repeated twice. On this substrate, a silicon carbide semiconductor layer was grown by CVD. No step bunching was observed, and this substrate was confirmed to have a high quality mirror surface.

### (EXAMPLE 3)

A silicon carbide single crystal substrate of substantially the same conditions as those in Example 2 was prepared, and a main face thereof was polished by CMP under substantially the same conditions as those in EXAMPLE 2. Thus, a silicon carbide single crystal substrate having a main face finished as a mirror surface was obtained.

Then, a surface of the substrate was oxidized using plasma in an oxygen atmosphere, and the substrate was washed in hydrofluoric acid to remove the oxide layer on the surface. On this substrate, a silicon carbide semiconductor layer was grown by CVD. No step bunching was observed, and this substrate was confirmed to have a high quality mirror surface.

### (COMPARATIVE EXAMPLE 1)

A silicon carbide single crystal substrate of substantially the same conditions as those in Example 1 was prepared, and a main face thereof was polished by CMP under substantially the same conditions as those in Example 1. Thus, a silicon carbide single crystal substrate having a main face finished as a mirror surface was obtained. On the main face, a silicon carbide semiconductor layer was grown by CVD. Striped step bunching was observed at many sites.

### (COMPARATIVE EXAMPLE 2)

A silicon carbide single crystal substrate of substantially the same conditions as those in Example 2 was prepared, and a main face thereof was polished by CMP under substantially the same conditions as those in Example 2. Thus, a silicon carbide single crystal substrate having a main face finished as a mirror surface was obtained. On the main face, a silicon carbide semiconductor layer was grown by CVD. Striped step bunching was observed at many sites.

### (SUMMARY OF THE EXPERIMENT RESULTS)

From the results of the experiments, it is understood that the surface residual substance on the silicon carbide single crystal substrate after CMP is removed by gas phase etching, resulting in the formation of a high quality silicon carbide semiconductor layer.

It is also understood that the surface residual substance on the silicon carbide single crystal substrate after CMP is oxidized by gas phase and removed the oxide, resulting in the formation of a high quality silicon carbide semiconductor layer.

### INDUSTRIAL APPLICABILITY

The present invention is preferably applicable for producing a silicon carbide single crystal substrate used for producing various semiconductor devices.

### REFERENCE SIGNS LIST

10, 61, 71 Silicon carbide single crystal substrate
10d Stepped feature
10S, 10R Main face
11 Affected layer
13, 73 Surface residual substance
13' Oxide
62, 72 Silicon carbide semiconductor layer
62a Different phase portion
72a Step bunching

## Claims

1. A method for producing a silicon carbide single crystal substrate (10), comprising steps of:
(A) preparing a silicon carbide single crystal substrate having a mechanically polished main face (10S) (S21);
(B) performing chemical mechanical polishing on the main face of the silicon carbide single crystal substrate using a polishing slurry containing abrasive grains dispersed therein to finish the main face as a mirror surface (S22);
(C'1) oxidizing at least a part of the main face finished as a mirror surface by a gas phase to form an oxide (13') (S23) ; and
(C'2) removing a surface residual substance (13') that is formed by the step (B) on the main face, with the oxide (S24),
wherein the surface residual substance includes another oxide containing silicon, carbon and oxygen,
wherein step (C'1) and step (C'2) are performed alternately in repetition a plurality of times, and
wherein, among a plurality of sessions of step (C'2) performed in repetition, the final session of step (C'2) is performed using an aqueous solution containing hydrofluoric acid.

2. The method for producing a silicon carbide single crystal substrate of claim 1, wherein in step (C'1), at least a part of a surface of the main face finished as a mirror surface is oxidized by any technique among wet oxidation, anodic oxidation, plasma oxidation, thermal oxidation, and ozone oxidation.

3. The method for producing a silicon carbide single crystal substrate of claim 2, wherein in each session other than the final session of step (C'2) among a plurality of sessions of step (C'2) performed in repetition, the oxide is etched by a gas phase technique or wet etching.

4. The method for producing a silicon carbide single crystal substrate of claim 4, wherein the etching in said each session other than the final session of step (C'2) performed by the gas phase technique is any of ion etching, reactive ion etching, plasma etching, reactive ion beam etching, and ion beam etching.

5. The method for producing a silicon carbide single crystal substrate of claim 4, wherein in said each session other than the final session of step (C'2), the oxide is etched by wet etching using an aqueous solution containing hydrofluoric acid.

6. The method for producing a silicon carbide single crystal substrate of any one of claims 1 through 5, wherein the main face finished as a mirror surface by the step (B) has a stepped feature derived from a single crystal structure of silicon carbide.

7. The method for producing a silicon carbide single crystal substrate of any one of claims 1 through 6, wherein the silicon carbide single crystal substrate is a single crystal substrate having a hexagonal structure, and an off-angle of the main face with respect to a C axis of a (0001) face is within 4 degrees.

## Patentansprüche

1. Verfahren zum Herstellen eines Siliziumcarbideinkristallsubstrats (10), umfassend die Schritte:
(A) Herstellen eines Siliziumcarbideinkristallsubstrats, besitzend eine mechanisch polierte Hauptfläche (10S) (S21);
(B) Durchführen von chemisch-mechanischem Polieren auf der Hauptfläche des Siliziumcarbideinkristallsubstrats unter Verwenden einer Polier-Slurry, enthaltend darin dispergierte Schleifkörner, um die Hauptfläche als eine Spiegelfläche (S22) zu fertigen;
(C'1) Oxidieren von mindestens einem Teil der Hauptfläche, die als eine Spiegeloberfläche gefertigt ist, durch eine Gasphase um ein Oxid (13') zu bilden (S23); und
(C'2) Entfernen einer Oberflächenrestsubstanz (13'), die durch Schritt (B) auf der Hauptfläche gebildet wird, mit dem Oxid (S24),
wobei die Oberflächenrestsubstanz ein anderes Oxid beinhaltet, enthaltend Silizium, Kohlenstoff und Sauerstoff,
wobei Schritt (C'1) und Schritt (C'2) alternierend eine Vielzahl von Malen wiederholt durchgeführt werden, und
wobei unter einer Vielzahl von Sitzungen von Schritt (C'2), die wiederholt durchgeführt werden, die letzte Sitzung von Schritt (C'2) unter Verwenden einer wässrigen Lösung, enthaltend Fluorwasserstoffsäure, durchgeführt wird.

2. Das Verfahren zum Herstellen eines Siliziumcarbideinkristallsubstrats nach Anspruch 1, wobei in Schritt (C'1) mindestens ein Teil einer Oberfläche der Hauptfläche, die als eine Spiegeloberfläche gefertigt ist, durch irgendeine Technik unter Nassoxidation, anodischer Oxidation, Plasmaoxidation, thermischer Oxidation und Ozonoxidation oxidiert wird.

3. Das Verfahren zum Herstellen eines Siliziumcarbideinkristallsubstrats nach Anspruch 2, wobei in jeder Sitzung, außer der letzten Sitzung von Schritt (C'2), unter einer Vielzahl von Sitzungen (C'2), die wiederholt durchgeführt werden, dass Oxid durch eine Gasphasentechnik oder durch Nassätzen geätzt wird.

4. Das Verfahren zum Herstellen eines Siliziumcarbideinkristallsubstrats nach Anspruch 3, wobei das Ätzen in besagter jeder Sitzung, außer der letzten Sitzung von (C'2), die durch die Gasphasentechnik durchgeführt wird, irgendeines von lonenätzen, reaktivem lonenätzen, Plasmaätzen, reaktivem Ionenstrahlenätzen und Ionenstrahlenätzen ist.

5. Das Verfahren zum Herstellen eines Siliziumcarbideinkristallsubstrats nach Anspruch 4, wobei in besagter jeder Sitzung, außer der letzten Sitzung von Schritt (C'2), dass Oxid durch Nassätzen unter Verwendung einer wässrigen Lösung, enthaltend Fluorwasserstoffsäure, geätzt wird.

6. Das Verfahren zum Herstellen eines Siliziumcarbideinkristallsubstrats nach irgendeinem der Ansprüche 1 bis 5, wobei die Hauptfläche, die als eine Spiegeloberfläche durch den Schritt (B) gefertigt ist, ein abgestuftes Merkmal besitzt, herrührend von einer Kristallstruktur von Siliziumcarbid.

7. Das Verfahren zum Herstellen eines Siliziumcarbideinkristallsubstrats nach irgendeinem der Ansprüche 1 bis 6, wobei das Siliziumcarbideinkristallsubstrat ein Siliziumcarbideinkristallsubstrat ist, das eine hexagonale Struktur besitzt, und wobei ein Winkel der Hauptfläche in Bezug auf eine C-Achse einer (0001) Fläche innerhalb von 4 Grad ist.

## Revendications

1. Procédé de production d'un substrat monocristallin de carbure de silicium (10), comprenant les étapes suivantes :
(A) préparation d'un substrat monocristallin de carbure de silicium présentant une face principale polie mécaniquement (10S) (S21) ;
(B) mise en oeuvre d'un polissage mécanique et chimique de la face principale du substrat monocristallin de carbure de silicium en utilisant un coulis de polissage contenant des grains abrasifs dispersés pour finir la face principale comme une surface de miroir (S22) ;
(C'1) oxydation d'au moins une partie de la face principale finie comme une surface de miroir par une phase gazeuse pour former un oxyde (13') (S23) ; et
(C'2) élimination d'une substance résiduelle en surface (13') qui est formée à l'étape (B) sur la face principale, avec l'oxyde (S24),
dans lequel la substance résiduelle en surface comprend un autre oxyde contenant du silicium, du carbone et de l'oxygène,
dans lequel l'étape (C'1) et l'étape (C'2) sont mises en oeuvre alternativement par une répétition une pluralité de fois, et
dans lequel, parmi une pluralité de sessions de mise en oeuvre répétée de l'étape (C'2), la session finale de l'étape (C'2) est mise en oeuvre en utilisant une solution aqueuse contenant de l'acide fluorhydrique.

2. Procédé de production d'un substrat monocristallin de carbure de silicium selon la revendication 1, dans lequel, à l'étape (C'1), au moins une partie d'une surface de la face principale finie comme une surface de miroir est oxydée par une technique quelconque parmi l'oxydation humide, l'oxydation anodique, l'oxydation au plasma, l'oxydation thermique et l'oxydation à l'ozone.

3. Procédé de production d'un substrat monocristallin de carbure de silicium selon la revendication 2, dans lequel, dans chaque session autre que la session finale de l'étape (C'2) parmi une pluralité de sessions de mise en oeuvre répétée de l'étape (C'2), l'oxyde est gravé par une technique à phase gazeuse ou une gravure humide.

4. Procédé de production d'un substrat monocristallin de carbure de silicium selon la revendication 4, dans lequel la gravure dans chaque dite session autre que la session finale de l'étape (C'2) mise en oeuvre par la technique à phase gazeuse est une technique quelconque parmi la gravure ionique, la gravure ionique réactive, la gravure au plasma, la gravure réactive à faisceau ionique et la gravure par faisceau ionique.

5. Procédé de production d'un substrat monocristallin de carbure de silicium selon la revendication 4, dans lequel, dans chaque dite session autre que la session finale de l'étape (C'2), l'oxyde est gravé par gravure humide en utilisant une solution aqueuse contenant de l'acide fluorhydrique.

6. Procédé de production d'un substrat monocristallin de carbure de silicium selon l'une quelconque des revendications 1 à 5, dans lequel la face principale finie comme une surface de miroir à l'étape (B) présente une caractéristique échelonnée dérivée d'une structure monocristalline de carbure de silicium.

7. Procédé de production d'un substrat monocristallin de carbure de silicium selon l'une quelconque des revendications 1 à 6, dans lequel le substrat monocristallin de carbure de silicium est un substrat monocristallin présentant une structure hexagonale, et l'angle de décalage de la face principale par rapport à l'axe C d'une face (0001) est inférieur ou égal à 4 degrés.
